# EUROPEAN PATENT SPECIFICATION

(11) **EP 1 215 303 B1**
(45) Date of publication and mention of the grant of the patent: **25.02.2009**
(21) Application number: 00127257.4
(22) Date of filing: 18.12.2000
(51) Int. Cl.: C23C 14/58, C23C 14/18

(54) **Method of treating a coated base material**
Verfahren zur Behandlung einer Beschichtung auf einem Substrat
Procédé de traitement d'un revêtement sur une surface

(43) Date of publication of application: 19.06.2002
(73) Proprietor: Alstom Technology Ltd, 5400 Baden (CH)
(72) Inventor: Zagorski, Alexandre, 5408 Ennetbaden (CH); Katsnelson, Savelii S., 630090 Novosibirsk (RU); Pozdniakov, Georgij A., 630055 Novosibirsk (RU)

(56) References cited:
- DE-A- 3 208 086
- US-A- 6 103 315
- MULLER G ET AL: "Oxide scale growth on MCrAlY coatings after pulsed electron beam treatment" 25TH INTERNATIONAL CONFERENCE ON METALLURGICAL COATINGS AND THIN FILMS, SAN DIEGO, CA, USA, 27 APRIL-1 MAY 1998, vol. 108-109, no. 1-3, pages 43-47, XP001004819 Surface and Coatings Technology, 10 Oct. 1998, Elsevier, Switzerland ISSN: 0257-8972

## Description

### FIELD OF INVENTION

The invention relates to a method for treating a coated base material to reduce the porosity of the coating and to improve the interface adhesion between the base material and the coating according to the preamble of claim 1.

### BACKGROUND OF THE INVENTION

Components designed for the use in the area of high temperature, e.g. blades or vanes of a gas turbine, are usually coated with resistant coatings. The coating protects the base material against corrosion and oxidation due to the thermal-chemical effect of the hot environment and consists of an alloy mostly using the elements Al and Cr, e.g. MCrAIY. MCrAIY protective overlay and bond coatings are widely known in the prior art. They are a family of high temperature coatings, wherein M is selected from one or a combination of iron, nickel and cobalt. As an example US-A-3,528,861 or US-A-4,585,418 are disclosing such kind of oxidation resistant coatings. US-A-4,152,223 as well discloses such method of coating and the coating itself.

When a typical MCrAIY coating is applied to the surface of a component made from a Ni base superalloy, a diffusion heat treatment is normally required in order to ensure a high quality bond between coating and base material.

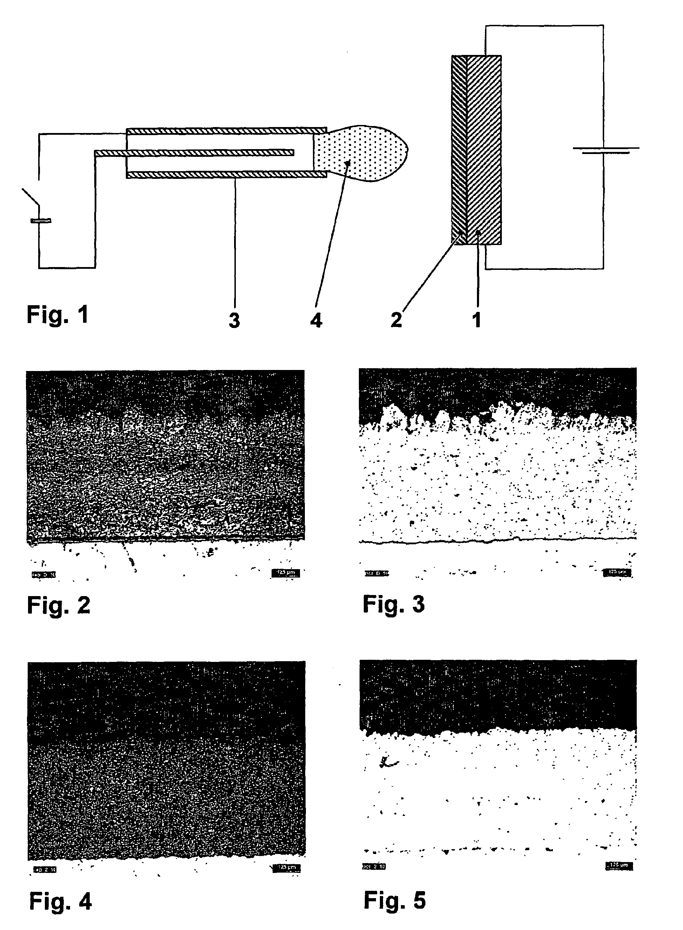

As seen in the Figure 2 and 3, which show the microstructure and porosity of a coated, but untreated base material, the porosity being about 1% and amplitude of surface roughness being about 100 microns.

During operation, the coating of the component is slowly oxidized and/or corroded away, and at some point in time it is either completely removed or reaches a minimum design limit which is no longer suitable for continued operation. Components subject to coating wear and/or other damage during service are removed from service at regular intervals for repair and/or reconditioning during which any residual coating is stripped, various repairs are made, and a new coating is applied. In addition to this, it is possible that new components are improperly coated during manufacturing and must have the coating stripped in order for an acceptable quality coating to be applied. One reason that such operations are necessary is the mentioned porosity of the coating and the bonding between surface of the component and the coating.

### SUMMARY OF THE INVENTION

It is the aim of the present invention to overcome the presented disadvantages. The invention solves the task to create a method for treating a base material to reduce the porosity of the coating, thereby densificate and homogenising the coating. In addition, an improvement in the interface adhesion between the coating and the base material by a densification of the interface between the base material and the coating should be achieved.

With the invention, a method according to the preamble of claim 1 was found, wherein the pulse of energy is provided by at least one gas or plasma pulse, the coated base material (1) is heated to soften the coating at the same time as the application of the gas or plasma pulse (4), wherein the combination of the heating and the pulse (4) application plastically deforms the coating (2) so as to reduce the coating's (2) porosity and to improve the interface adhesion between the base material (1) and the coating (2).

High power energy input through the coating surface combined with an elevated coating/substrate temperature of about 600°C - 1100°C is applied to create high mechanical/thermo-mechanical stresses in the coating material, which exceed its plasticity limit. The temperature range mentioned above is typical for softening of MCrAIY alloys and might change if other materials are subject of the treatment according to the invention. Such an action results in the plastic deformation of the material. Of course, during this treatment the base material is not melted. With the method according to the invention, with advantage a densification and homogenising of the coating is achieved leading to a lower porosity of the coating due to the closure or the collapse of pores and inter-particle flaws. The interface adhesion between the base material and the coating is improved.

In addition, the bulging parts of the coating surface are deformed and eliminated and, thus, the roughness of the surface of the coating is reduced. Subsequently, being applied to the overlay coatings of blades or vanes such a treatment improves their aerodynamic characteristic and reduces heat fluxes from the hot gases to the detail.

The high-speed, high-enthalpy gas or plasma pulses at elevated temperature can be repeated to increase the efficiency of the claimed method and to enhance the mentioned effects of reducing the porosity of the coating and the surface roughness of the base material and for further improving the interface adhesion between the base material and the coating. The temperature should be high enough in order to have stresses exceeding yield stress within the coating material. When the temperature is above 600°C the yield stress of MCrAIY drops rapidly with the temperature increase.

In an advantageous embodiment the base material is a nickel based alloy, which is coated with MCrAIY. This is the case for e.g. gas turbine components, such as blades or vanes.

The coating and the subjecting of the coated material to high-speed, high-enthalpy gas or plasma pulses can be done at the same time, thereby reaching the same efficiency at a reduced amount of time.

Being applied to the substrate surface prior to the coating, high energy fluxes create high thermo-mechanical stresses at the interfaces between the substrate and impurities leading to their removal from the substrate.

In general, the high-speed, high-enthalpy gas or plasma pulses can be created by an electro-magnetic or an electro-thermal pulse plasma gun, detonation gun or the like.

Further advantageous embodiments of the invention can be found in the dependant claims 2 to 8.

### BRIEF DESCRIPTION OF DRAWINGS

The invention is illustrated in the accompanying drawing in which
- **Fig. 1**: shows an experimental apparatus for operating the process,
- **Fig. 2, 3**: the microstructure and porosity of a coated, but untreated base material and
- **Fig. 4, 5**: the microstructure and porosity of a coated base material after the application of a pulse plasma gun according to the invention.

The drawings only show the parts important for the invention.

### DETAILED DESCRIPTION OF THE INVENTION

The invention refers to a method for treating a coated base material to reduce the porosity of the coating and to improve the interface adhesion between the base material and the coating. As an example, the base material could be a component such as a blade or a vane of a gas turbine. Thereby, often the components consist of a Nickel based superalloy, using as a protective coating MCrAIY. MCrAlY protective overlay and bond coatings are widely known in the prior art. They are a family of high temperature coatings, wherein M is selected from one or a combination of iron, nickel and cobalt. As an example US-A-3,528,861 or US-A-4,585,481 are disclosing such types of oxidation resistant coatings.US-A-4,152,223 as well discloses such a method of coating and the coating itself. Possible ways of deposition are known in the state of the art as chemical or physical vapour deposition (CVD, PVD), atmospheric plasma spray (APS), low pressure plasma spray (LPPS), vacuum plasma spray (VPS), high velocity oxidant fuel (HVOF), Cold Spray or any other process suitable for deposition. After the coating with MCrAIY a diffusion heat-treatment takes place known in the prior art.

Within the proposed method the coated base material is subjected to high-speed, high-enthalpy gas or plasma pulses, the high-enthalpy gas or plasma pulses being directed to the coating and wherein the coated base material is simultaneously with when the high-enthalpy gas or plasma pulses taking place heated to a temperature of 600° - 1000° C. The temperature range mentioned above is typical for softening alloys and might change if other materials are subject of the treatment according to the invention. In general, the temperature of the coated base material is selected according to the energy of at least one gas or plasma pulse and/or the mechanical properties of the coating material.

With this method according to the invention an advantageous densification and homogenising of the coating is achieved due to the closure or the collapse of pores and inter-particle flaws, leading to a lower porosity of the coating. Subsequently, the interface adhesion between the base material and the coating is improved.

In addition, any protruding parts of the coating surface are eliminated, thus, reducing the roughness of the surface of the coating and thereby positively influencing the aerodynamic and heat characteristics of the whole part. This is point especially important, if the coating is an overlay coating which is in direct contact with the hot gases of the environment.

High power energy input through the coating surface combined with an elevated coating/substrate temperature is applied to create high mechanical/thermo-mechanical stresses in the coating material, which exceed the material coatings plasticity limit. This results in the plastic deformation of the material. During this treatment the base material is not melted. The temperature should be high enough in order to create stresses exceeding the plasticity limit within the coating. If temperature is above approximately 600° C the yield stress of MCrAIY alloys drops rapidly with increasing temperature.

The method producing the plasma pulses can be realized by means of
- Electro-magnetic or electro-thermal pulse plasma gun, which creates a high-speed, high-enthalpy plasma flow. This flow impacts the coating/substrate surface and creates high-pressure and large heat fluxes, which result in a series of shock waves inside the surface layer and high thermal gradients. If the coating/substrate prior to the treatment has been heated up close enough to the temperature 600° - 1100° C and if pressure and/or thermo-mechanical stresses induced by temperature gradients exceed the plasticity limit of the material, a plastic deformation takes place with the above mentioned effects on the material. The temperature range mentioned above is typical for softening alloys and might change if other materials are subject of the treatment according to the invention. An apparatus for the method is shown in Fig.1. An electrically heated base material 1, coated with a coating 2 is subjected to plasma pulses 4 created by a coaxial plasma gun 3.
- Other methods, which create high-speed, high-enthalpy gas/plasma flows (Detonation-guns, plasma torches etc.)

The step of heating the coated sample can realized by
- Laser irradiation which would create high temperature gradients and thermo-mechanical stresses. The feature of this method is that unlike many other methods of laser surface treatment it does not require re-melting or ablation of the surface and, respectively, does not create excessive thermo-mechanical stresses in the substrate material.
- E-beam with the same effect and distinctive features as laser irradiation or
- High power sources of radiation (capillary discharge, electric arc, etc.)

The step of coating and the step of subjecting the coated material to high-speed, high-enthalpy gas or plasma pulses can be performed at the same time, thus reducing the process time required.

The base material can even be subjected to high-speed, high-enthalpy gas or plasma pulses prior to coating. This leads to the cleaning of the base material surface prior to coating, thus further enhancing the efficiency of the claimed method. This step of the method should be performed at ambient temperature without pre-heating.

Experimental results, Influence of gas or plasma blasting on the coating structure.

The following experiments illustrate the efficiency of the claimed invention. In all experiments and attached pictures IN738 was used as base material which was coated with SV20. The compositions are shown in table 1 (wt.-%).

**Tab. 1**

| Alloy | Ni | Cr | Al | Si | Y | Ta | Co | Ti | Mo | Zr | Nb | B | C | W |
|---|---|---|---|---|---|---|---|---|---|---|---|---|---|---|
| IN738 | Bal. | 16 | 3.4 | -- | -- | 1.75 | 8.5 | 3.4 | 1.75 | 0.12 | 0.85 | 0.012 | 0.13 | 2.6 |
| SV 20 | Bal. | 25 | 5 | 3 | 0.5 | 1 | -- | -- | -- | -- | -- | -- | -- | -- |

The coated, but untreated sample is shown in Fig. 2 and 3. The series of experiments with different preheating-temperatures and different number of plasma pluses has been performed. For the result of the experiment presented in Fig. 4,5 the temperature was 900°C and the number of pulses was 30. The duration of a shot was in the range of 50-100 µs. In the experiments Argon and air was used in a pressure range of 250 to 600 Pa. During the plasma shot a pressure of 0.5 - 1.0 MPa is developed at the sample surface. It can be seen that pulsed plasma treatment eliminates the porosity nearly completely and creates an extremely fine microstructure. From Fig. 4 and 5 follows that stresses applied during a shot are comparable to the yield stress of the coating, which is in the range of 1 MPa at 900°C. It was found, that even a small number of shots (i.e. the number of cycles was varied from 1 to 30, not shown in pictures) makes drastic changes in the coating structure.

If the temperature is lower than the temperature of 900°C, multiple pulses are required in order to modify the coating significantly. If the temperature is lower than 600°C the parameters of the plasma gun used in experiments were not sufficient to produce any visible effect of porosity reduction.

One can see that all blasted samples have significantly smaller surface roughness that the untreated ones. An As-sprayed sample has a porosity of about 1% and amplitude of surface roughness of about 100 microns, the treated sample (plasma blasted, Fig. 4, 5) has a porosity of 0.1 % and roughness of about 40 microns; other treated samples even feature a porosity in the range of 0.05 to 0.1 %. Therefore the porosity is reduced by 10, the roughness by about 2 to 3 times.

It is obvious that such a treatment with optimized parameters (pre-heating temperature and pulse energy) could be a very efficient tool for a coating modification.

In an other sample, not shown in pictures, a pre-heating temperature of about 1100°C was used. Again, the number of cycles were varied from 1 to 30. The result were similar to the presented results at 900°C. But, just one pulse is enough to reduce porosity nearly completely, if the mechanical properties of SV20 are negligible compared to the pulse pressure.

### REFERENCE NUMBERS

- 1: Base material
- 2: Coating
- 3: Plasma gun
- 4: Plasma pulse

## Claims

1. A method for treating a base material (1) coated with a MCrAIY coating (2) wherein the coating (2) is subjected to a high-speed, high-enthalpy pulse of energy **characterized in that** said pulse of energy is provided by at least one gas or plasma pulse (4) and the coated base material (1) is heated to soften the coating at the same time as the application of the gas or plasma pulse (4), wherein the combination of the heating and the pulse (4) application plastically deforms the coating (2) so as to reduce the coating's (2) porosity and to improve the interface adhesion between the base material (1) and the coating (2).

2. The method according to claim 1 wherein the coating (2) is homogenized by said combination of heating and pulse application.

3. The method according to claims 1 or 2 wherein the coated base material (1) is pre-heated.

4. The method according to any one of claims 1 to 3,
wherein the temperature of the coated base material (1) is 600°C - 1100°C.

5. The method according to anyone of the claims 1 to 4,
wherein the method further includes applying the at least one pulse (4) to the coated base material (1) during application of the coating (2).

6. The method according to anyone of the claims 1 to 5, wherein the method further includes applying the pulse (4) to the base material (1) prior to application of the coating (2).

7. The method according to claim 6 wherein the step of claim 6 is performed at ambient temperature.

8. The method according to any of the claims 1 to 7, wherein the at least one pulse (4) is created by an electro-magnetic or an electro-thermal pulse (4) plasma gun or a detonation gun.

## Patentansprüche

1. Verfahren zur Behandlung eines mit einer MCrAlY-Beschichtung (2) beschichteten Basismaterials (1), wobei die Beschichtung (2) einem Energieimpuls hoher Geschwindigkeit und hoher Enthalpie ausgesetzt wird, **dadurch gekennzeichnet, daß** der Energieimpuls durch mindestens einen Gas-oder Plasmaimpuls (4) bereitgestellt wird und das beschichtete Basismaterial (1) erhitzt wird, um die Beschichtung gleichzeitig während der Anwendung des Gas- oder Plasmaimpulses (4) zu erweichen, wobei die Kombination von Erhitzung und Anwendung des Impulses (4) die Beschichtung (2) plastisch verformt, um so die Porosität der Beschichtung (2) zu verringern und die Grenzflächenadhäsion zwischen dem Basismaterial (1) und der Beschichtung (2) zu verbessern.

2. Verfahren nach Anspruch 1, wobei die Beschichtung (2) durch die Kombination von Erhitzung und Impulsanwendung homogenisiert wird.

3. Verfahren nach Anspruch 1 oder 2, wobei das beschichtete Basismaterial (1) vorgewärmt wird.

4. Verfahren nach einem der Ansprüche 1 bis 3, wobei die Temperatur des beschichteten Basismaterials (1) 600°C - 1100°C beträgt.

5. Verfahren nach einem der Ansprüche 1 bis 4, wobei das Verfahren ferner das Anwenden des mindestens einen Impulses (4) auf das Basismaterial (1) während des Aufbringens der Beschichtung (2) umfaßt.

6. Verfahren nach einem der Ansprüche 1 bis 5, wobei das Verfahren ferner das Anwenden des mindestens einen Impulses (4) auf das Basismaterial (1) vor dem Aufbringen der Beschichtung (2) umfaßt.

7. Verfahren nach Anspruch 6, wobei der Schritt von Anspruch 6 bei Umgebungstemperatur ausgeführt wird.

8. Verfahren nach einem der Ansprüche 1 bis 7, wobei der mindestens eine Impuls (4) durch eine Plasmakanone mit elektromagnetischem oder elektrothermischem Impuls (4) oder eine Detonationskanone erzeugt wird.

## Revendications

1. Procédé de traitement d'un matériau de base (1) revêtu d'un revêtement de MCrAlY (2), le revêtement (2) étant soumis à une impulsion d'énergie rapide d'enthalpie élevée,
le procédé étant **caractérisé en ce que** ladite impulsion d'énergie est produite par au moins une impulsion de gaz ou de plasma (4) et le matériau de base (1) revêtu est chauffé dans le but de ramollir le revêtement simultanément à l'application de l'impulsion de gaz ou de plasma (4),
la combinaison du chauffage et de l'application de l'impulsion (4) entraînant la déformation plastique du revêtement (2) de manière à réduire sa porosité et à améliorer l'adhérence interfaciale entre le matériau de base (1) et le revêtement (2).

2. Procédé selon la revendication 1, le revêtement (2) étant homogénéisé par ladite combinaison du chauffage et de l'application de l'impulsion.

3. Procédé selon les revendications 1 ou 2, le matériau de base (1) revêtu étant préchauffé.

4. Procédé selon l'une quelconque des revendications 1 à 3, la température du matériau de base (1) revêtu étant comprise entre 600°C et 1100°C.

5. Procédé selon l'une quelconque des revendications 1 à 4, comprenant en outre l'application d'au moins une impulsion (4) au matériau de base (1) revêtu au cours de l'application du revêtement (2).

6. Procédé selon l'une quelconque des revendications 1 à 5, comprenant en outre l'application de l'impulsion (4) au matériau de base (1) préalablement à l'application du revêtement (2).

7. Procédé selon la revendication 6, l'étape de la revendication 6 étant mise en oeuvre à température ambiante.

8. Procédé selon l'une quelconque des revendications 1 à 7, ladite au moins une impulsion (4) étant créée par un canon à plasma à impulsion (4) électromagnétique ou électrothermique ou par un canon à détonation.
